(19) Europäisches Patentamt
European Patent Office
Office européen des brevets

(11) **EP 2 038 671 B1**

(12) **FASCICULE DE BREVET EUROPEEN**

(45) Date de publication et mention de la délivrance du brevet:
**02.08.2017 Bulletin 2017/31**

(21) Numéro de dépôt: **07803924.5**

(22) Date de dépôt: **22.06.2007**

(51) Int Cl.:
***G01R 33/09*** *(2006.01)*      *G01R 15/20* *(2006.01)*

(86) Numéro de dépôt international:
**PCT/FR2007/051501**

(87) Numéro de publication internationale:
**WO 2007/148028 (27.12.2007 Gazette 2007/52)**

(54) **PROCEDE ET SYSTEME POUR AJUSTER LA SENSIBILITE D'UN CAPTEUR MAGNETORESISTIF**

VERFAHREN UND SYSTEM ZUR EINSTELLUNG DER SENSITIVITÄT EINES MAGNETORESISTIVEN SENSORS

METHOD AND SYSTEM FOR ADJUSTING THE SENSITIVITY OF A MAGNETORESISTIVE SENSOR

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **22.06.2006 FR 0652598**

(43) Date de publication de la demande:
**25.03.2009 Bulletin 2009/13**

(73) Titulaire: **Commissariat à l'Énergie Atomique et aux Énergies Alternatives 75015 Paris (FR)**

(72) Inventeurs:
• **FERMON, Claude**
  **F-91400 Orsay (FR)**
• **PANNETIER-LECOEUR, Myriam**
  **F-91440 Bures Sur Yvette (FR)**

(74) Mandataire: **Desormiere, Pierre-Louis et al Cabinet Beau de Loménie 158, rue de l'Université 75340 Paris Cedex 07 (FR)**

(56) Documents cités:
**US-A- 4 053 829      US-A- 4 296 377
US-A- 4 361 805      US-A1- 2004 096 700
US-A1- 2004 248 327      US-B2- 7 054 118**

**Description**

La présente invention a pour objet un procédé et un système pour ajuster la sensibilité d'un capteur magnétorésistif.

Les capteurs magnétorésistifs tels que les capteurs à magnétorésistance anisotrope (AMR), les capteurs à magnétorésistance géante (GMR) ou les capteurs à magnétorésistance tunnel (TMR) sont utilisés de façon très fréquente pour effectuer des mesures de champs magnétiques en particulier dans les têtes de lecture.

Dans un faible champ magnétique, les capteurs magnétorésistifs se caractérisent par une grande variation, ce qui leur confère une grande sensibilité pour ces mesures de faibles champs magnétiques.

Actuellement, lorsque l'on souhaite mesurer des champs magnétiques relativement élevés (>10 mT), on utilise généralement des capteurs à effet Hall qui présentent l'avantage d'être linéaires jusqu'à des valeurs de champs très élevées (> 15 T). Toutefois, la sensibilité des capteurs à effet Hall reste faible comparée à celle que présentent les capteurs magnétorésistifs dans le domaine des faibles champs magnétiques.

On connaît également des systèmes magnétorésistifs tels que les systèmes présentant une magnétorésistivité colossale (capteurs CMR) qui offrent une variation de résistance non négligeable sur une large plage de valeurs de champ magnétique. La linéarité de ces systèmes est cependant faible et ils manquent de stabilité en température.

On connaît encore l'utilisation de champs magnétiques produits par des aimants permanents pour accroître la sensibilité du comportement magnétorésistif et en particulier pour réduire le bruit électrique créé lors de la formation de domaines magnétiques de mesure (voir par exemple les documents GB 2 272 561 A ; WO 95/35508 ; US7054118 B2 et WO 96/28812).

Par ailleurs, le document DE 1011313A est relatif à des capteurs magnétorésistifs dont la linéarité est améliorée grâce à l'application d'un champ magnétique connu créé par des aimants permanents.

Il reste toutefois un besoin pour des capteurs magnétorésistifs dont la réponse soit modifiée afin que leur sensibilité soit ajustée, en particulier pour la mesure de champs magnétiques élevés, ou de courants d'intensité importante.

La présente invention vise ainsi à remédier aux inconvénients des systèmes connus de mesure de champ magnétique à l'aide de capteurs magnétorésistifs et à remédier à une limitation de ces capteurs en ce qui concerne leur réponse par rapport à un champ magnétique appliqué.

En particulier, un capteur magnétorésistif tel qu'un capteur du type AMR, GMR ou TMR est limité en réponse en champ du fait d'une saturation rapide.

L'invention vise à permettre de mesurer des champs magnétiques ou des courants élevés à l'aide de capteurs magnétorésistifs.

Ces buts sont atteints par un procédé selon la revendication 1 et un système selon la revendication 5. En outre, ils sont atteints grâce à un procédé pour ajuster la sensibilité d'un dispositif comprenant au moins un capteur magnétorésistif et augmenter la plage de réponse de ce dispositif par rapport à un champ magnétique extérieur, caractérisé en ce qu'il consiste à appliquer un champ magnétique de polarisation prédéterminé connu $H_{bias}$ selon une direction telle qu'il présente une composante de champ non nulle perpendiculaire à une direction de détection dudit capteur magnétorésistif qui correspond également à une direction d'anisotropie d'une couche dudit capteur magnétorésistif, de telle sorte que le champ magnétique à mesurer puisse être déterminé par une fonction monotone à partir de la variation de résistance dudit capteur magnétorésistif.

De façon plus particulière, on applique le champ magnétique de polarisation prédéterminé connu $H_{bias}$ destiné à étendre la plage de réponse du dispositif comprenant au moins un capteur magnétorésistif pour mesurer un champ magnétique extérieur H, on détermine la réponse dudit dispositif en divisant la valeur de champ magnétique extérieur H à mesurer par la racine carrée de la somme du carré de la valeur du champ magnétique extérieur H à mesurer et du carré de la valeur du champ magnétique de polarisation prédéterminé $H_{bias}$.

D'une façon générale, la conception d'un capteur magnétorésistif présentant une anisotropie bien définie combinée à l'application d'un champ magnétique de polarisation $H_{bias}$ appliqué selon la direction de cette anisotropie permet d'obtenir une réponse du capteur magnétorésistif qui soit prévisible et précise même dans le cas de champs magnétiques externes de valeur élevée.

Dans le cas où le procédé est destiné à ajuster la sensibilité d'un dispositif comprenant au moins un capteur à magnétorésistance anisotrope, on applique le champ magnétique de polarisation prédéterminé connu $H_{bias}$ selon une direction telle qu'il présente une composante de champ non nulle selon une direction perpendiculaire à la direction de circulation du courant dans ledit capteur.

Dans le cas où le procédé est destiné à ajuster la sensibilité d'un dispositif comprenant au moins un capteur à magnétorésistance géante ou un capteur à magnétorésistance tunnel comportant une couche ferromagnétique dure piégée dans une direction de référence, on applique le champ magnétique de polarisation prédéterminé connu $H_{bias}$ selon une direction telle qu'il présente une composante de champ non nulle selon une direction perpendiculaire à ladite direction de référence de la couche ferromagnétique dure.

Selon l'invention, le champ magnétique de polarisation prédéterminé connu $H_{bias}$ n'est pas homogène et présente des variations connues entre une valeur minimale $H_{biasmin}$ et une valeur maximale $H_{biasmax}$.

L'invention concerne également un système pour mesurer des champs magnétiques ou des courants élevés à l'aide d'au moins un capteur magnétorésistif, caractérisé en ce qu'il comprend des moyens d'application d'un champ magnétique de polarisation prédéterminé connu $H_{bias}$ selon une direction telle qu'il présente une composante du champ non nulle perpendiculaire à une direction de détection dudit capteur magnétorésistif qui correspond également à une direction d'anisotropie d'une couche dudit capteur magnétorésistif, des moyens de mesure de la variation de résistance dudit capteur magnétorésistif et des moyens de détermination du champ magnétique extérieur à mesurer H à partir de ladite variation de résistance mesurée, la résistance du capteur étant soumise à une fonction monotone de variation.

Selon un mode particulier de réalisation, le capteur magnétorésistif est une magnétorésistance anisotrope et les moyens d'application d'un champ magnétique de polarisation prédéterminé connu $H_{bias}$ sont adaptés pour que ledit champ présente une composante de champ non nulle perpendiculaire à la circulation de courant dans ledit capteur.

Selon un autre mode de réalisation particulier, le capteur magnétorésistif est un capteur à magnétorésistance géante ou un capteur à magnétorésistance tunnel comportant une couche ferromagnétique dure piégée dans une direction de référence et les moyens d'application d'un champ magnétique de polarisation prédéterminé connu $H_{bias}$ sont adaptés pour que ledit champ présente une composante de champ non nulle selon une direction perpendiculaire à ladite direction de référence de la couche ferromagnétique dure.

Le système selon l'invention peut être réalisé de telle sorte que le capteur magnétorésistif présente une forme de C à coins carrés ou une forme de serpentin avec des bras transversaux de faible longueur et des bras longitudinaux de plus grande longueur, ces derniers étant alignés selon la direction de l'axe de facile aimantation de couches ferromagnétiques douces contenues dans ledit capteur et selon la direction dudit champ magnétique de polarisation prédéterminé connu $H_{bias}$.

Selon un mode de réalisation possible, les moyens d'application d'un champ magnétique de polarisation prédéterminé connu $H_{bias}$ comprennent au moins un aimant permanent.

Dans ce cas selon une première possibilité, l'aimant permanent est placé au-dessus ou au-dessous dudit capteur magnétorésistif et possède une aimantation planaire.

Selon une autre possibilité, le système comprend au moins un aimant permanent placé à côté dudit capteur magnétorésistif avec une aimantation dirigée de manière à créer dans ledit capteur un champ planaire.

Selon une caractéristique particulière de l'invention, l'aimant permanent est adapté pour que les variations thermiques du champ magnétique rémanent créé par l'aimant permanent compensent la variation de sensibilité des capteurs magnétorésistifs.

A titre d'exemple, le ou les aimants permanents peuvent être réalisés par électrodéposition, sérigraphie ou lithographie de couches magnétiques déposées.

Selon un autre mode de réalisation possible, les moyens d'application d'un champ magnétique de polarisation prédéterminé connu $H_{bias}$ comprennent au moins une bobine d'électroaimant.

Dans ce cas, le système peut comprendre des moyens d'ajustement du courant circulant dans ladite bobine d'électroaimant pour compenser les variations thermiques de sensibilité du capteur magnétorésistif.

Selon encore un autre mode de réalisation, le capteur est placé à proximité d'un fil conducteur traversé par un courant dont l'intensité est à déterminer, le système comprend des moyens de détermination de l'intensité dudit courant à partir de la valeur du champ magnétique produit par ledit courant et détecté par ledit capteur magnétorésistif, et le capteur magnétorésistif et ledit fil conducteur sont disposés de telle manière que ledit champ magnétique détecté soit perpendiculaire audit champ magnétique de polarisation prédéterminé connu $H_{bias}$.

D'autres caractéristiques et avantages de l'invention ressortiront de la description suivante de modes particuliers de réalisation, en référence aux dessins annexés, sur lesquels :

-   la Figure 1 montre les composantes du champ magnétique appliqué dans le cadre du procédé selon l'invention,
-   la Figure 2a montre une vue schématique en coupe montrant l'empilement de couches constituant un capteur à magnétorésistance géante (GMR),
-   la Figure 2b est une vue d'un exemple de configuration de capteur GMR en forme de C à coins carrés,
-   la Figure 2c est une vue d'un autre exemple de configuration de capteur GMR en forme de serpentin,
-   la Figure 3 montre une vue schématique d'un ensemble de capteurs GMR associés à un aimant permanent intégré au-dessus de ces capteurs,
-   la Figure 4 montre une vue schématique d'un ensemble de capteurs GMR associés à des aimants permanents disposés latéralement par rapport à ces capteurs, et
-   la Figure 5 montre une vue schématique d'un exemple de dispositif selon l'invention adapté à la mesure de courant dans un fil conducteur.

On rappelle tout d'abord que les capteurs magnétorésistifs comprennent une couche ferromagnétique douce, qui est généralement composée de NiFe ou de NiFe/CoFe, et dont la direction d'aimantation peut tourner librement dans un plan lorsqu'un champ magnétique externe est appliqué.

Dans le cas de capteurs à magnétorésistance anisotrope (AMR), la résistance varie comme l'angle $\theta$ entre l'aimantation de la couche douce et la direction du courant injecté.

Dans le cas de capteurs à magnétorésistance géante (GMR) ou de capteurs à magnétorésistance tunnel (TMR), la résistance varie comme l'angle $\theta$ entre l'aimantation de cette couche douce et l'aimantation d'un couche ferromagnétique dure qui constitue une couche de référence.

La résistance R du capteur en fonction de l'angle $\theta$ peut s'exprimer de la façon suivante en fonction de composantes $R_0$ et $R_1$ :

$$R = R_0 + R_1 \cos \theta \qquad (1)$$

Pour des capteurs GMR, le rapport $R_1/R_0$ peut varier entre 0,05 et 0,15 tandis que, pour des capteurs TMR, le rapport $R_1/R_0$ peut atteindre des valeurs de l'ordre de 4 à la température ambiante.

La direction de mesure est généralement donnée à $\theta = 0$.

L'angle $\theta$ est l'angle formé entre la direction de référence (couche de référence ou direction du courant) et l'aimantation de la couche ferromagnétique douce.

L'aimantation de la couche ferromagnétique douce suit le champ magnétique externe.

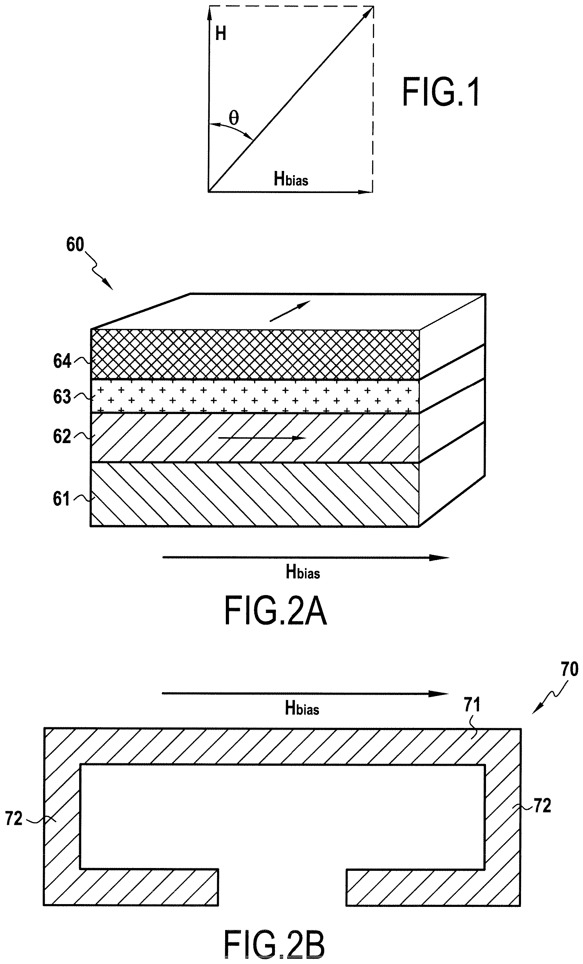

Selon l'invention, on applique un champ magnétique de polarisation $H_{bias}$ présentant une valeur déterminée connue, dans le plan du capteur, à un angle égal à $\pi/2$ par rapport à la direction de détection du capteur magnétorésistif sensible à un champ magnétique H (figure 1).

Si le champ magnétique de polarisation $H_{bias}$ est constant, la variation de résistance du capteur en fonction du champ magnétique extérieur appliqué H est donné par la formule suivante :

$$R = R_0 + R_1 \cos\theta = R_0 + R_1 \frac{H}{\sqrt{H^2 + H_{bias}^2}} \qquad (2)$$

Pour les champs magnétiques H de faible valeur, la variation de résistance est linéaire :

$$R = R_0 + R_1 \cos\theta = R_0 + R_1 \frac{H}{H_{bias}}$$

Le terme d'ordre suivant dans le développement de l'équation (2) est donné par $R_1 \dfrac{H^3}{2H_{bias}^2}$.

A partir de l'équation (2), on peut déduire la sensibilité qui s'exprime de la façon suivante :

$$\frac{R_1 H_{bias}^2}{\left(H^2 + H_{bias}^2\right)^{3/2}} \qquad (3)$$

On peut effectuer un calcul direct de l'inverse de l'équation (2) en traitant les données acquises.

Il s'ensuit que si une variation de résistance $\delta R = R_1 \cos\theta$ est observée, on peut en déduire le champ magnétique externe appliqué H de la façon suivante :

$$H = \frac{\delta R / R_1}{\sqrt{1 - (\delta R / R_1)^2}} H_{bias}$$

Lorsqu'il s'agit de mesurer l'intensité d'un courant circulant dans un fil conducteur, il suffit de mesurer le champ magnétique créé par ce courant à l'extérieur du conducteur. Si l'intensité du courant circulant dans le fil conducteur est I, la valeur du champ magnétique H créé à une distance r du conducteur est grossièrement donnée par la formule

$$\mu_0 \frac{I}{2r}$$ où $\mu 0$ est la perméabilité magnétique du vide.

On peut utiliser avantageusement en tant que capteurs magnétorésistifs des capteurs GMR ou TMR. Les capteurs GMR présentent une variation de résistance plus faible que les capteurs TMR, mais en revanche ils acceptent un courant plus élevé et présentent un bruit plus faible à faible fréquence.

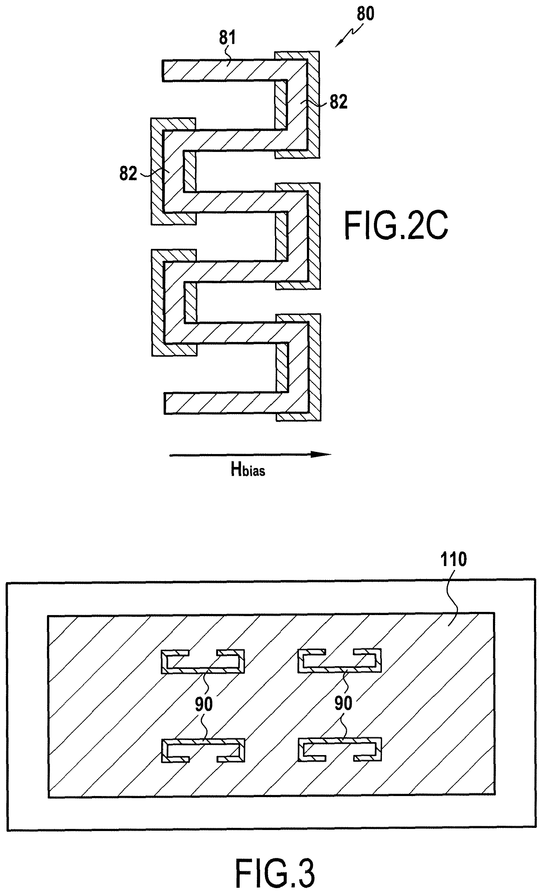

La Figure 2 montre un exemple d'empilement de couches constituant un capteur GMR présentant une configuration en vanne de spin avec des anisotropies croisées. Une couche libre 62 ou couche ferromagnétique douce présente un axe de facile aimantation perpendiculaire à une couche de référence 64 ou couche ferromagnétique dure de la vanne de spin.

La couche libre 62 est habituellement constituée de deux couches de NiFe et de CoFe. Elle est séparée de la couche de référence 64 par une mince couche de cuivre 63.

La couche de référence 64 est constituée d'une couche antiferromagnétique couplée à une couche ferromagnétique et peut comprendre par exemple un empilement CoFe/IrMn. Selon une variante de réalisation, la couche de référence 64 peut contenir un ensemble antiferromagnétique tel qu'un ensemble de trois couches formant un empilement CoFe/Ru/CoFe.

Le champ magnétique de polarisation $H_{bias}$ est appliqué dans la direction de l'axe de facile aimantation de la couche libre 62 tandis que le champ magnétique extérieur à mesurer est appliqué selon la direction de la couche de référence 64.

Un ensemble antiferromagnétique artificiel présente l'avantage d'être insensible aux champs externes appliqués et en particulier au champ magnétique de polarisation $H_{bias}$ et donc de permettre d'obtenir une très faible erreur par rapport à la formule (2) même en champ fort.

De façon classique, un empilement 60 de capteur GMR est associé par microfabrication à un ensemble de contacts pour deux ou quatre points de mesure.

Un empilement de capteurs GMR peut présenter la forme d'un C à coins carrés (empilement 70 de la Figure 2b) avec un bras longitudinal 71 et deux bras transversaux plus courts 72, ou la forme d'un serpentin (empilement 80 de la Figure 2c) avec des bras longitudinaux 81 et des bras transversaux de liaison 82 plus courts court-circuités pour diminuer le bruit magnétique.

Dans tous les cas, les bras longitudinaux 71, 81 sont alignés avec l'axe de facile aimantation de la couche libre et donc avec la direction du champ magnétique de polarisation $H_{bias}$.

Un champ magnétique $H_{bias}$ peut être créé dans le plan d'un ou plusieurs capteurs GMR 90 à l'aide d'un ou plusieurs aimants permanents 110, 121, 122.

On peut ainsi disposer un aimant permanent 110 au-dessus ou au-dessous de capteurs magnétorésistifs 90 avec une aimantation planaire (Figure 3).

On peut également disposer un ou plusieurs aimants permanents 121, 122 à côté de capteurs magnétorésistifs 90, également avec une aimantation planaire, ou avec une aimantation orthogonale orientée de manière à créer un champ planaire dans les capteurs 90.

Les aimants permanents 110, 121, 122 peuvent être agencés de manière à créer un champ magnétique $H_{bias}$ homogène et leur composition peut être choisie en fonction des propriétés magnétiques requises et des techniques de fabrication choisies. Des aimants permanents à base de terres rares constitués par exemple par des alliages NbFeB ou SmCo présentent l'avantage d'avoir un champ rémanent très élevé et une très grande coercivité.

Un procédé de fabrication des aimants permanents compatible avec la fabrication de microcapteurs sur des microplaquettes consiste à utiliser des techniques de sérigraphie avec des encres contenant des poudres d'aimants durs. On peut ainsi obtenir des coercitivités allant jusqu'à 2 T et des champs rémanents allant jusqu'à 1 T.

Un autre procédé de fabrication consiste à utiliser les techniques d'électrodéposition. On peut ainsi facilement déposer avec cette technique des alliages CoPt pour obtenir la forme finale désirée.

Lorsque l'on souhaite créer un champ magnétique de polarisation $H_{bias}$ homogène sur les capteurs 90, on doit choisir des aimants permanents de taille suffisamment grande et d'épaisseur suffisante pour que le champ magnétique créé soit suffisamment élevé.

Le champ magnétique de polarisation $H_{bias}$ peut également être créé par une bobine d'électroaimant. Dans ce cas, il est plus facile d'ajuster la sensibilité et l'immunité face aux champs extérieurs appliqués, mais ce mode de réalisation implique une certaine consommation de courant.

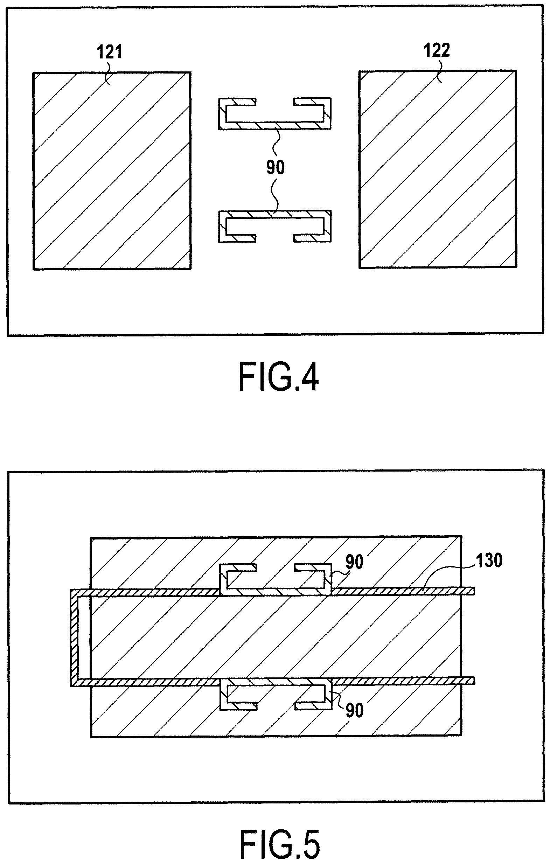

La Figure 5 montre un exemple de dispositif de mesure de courant selon l'invention, avec une ligne conductrice 130 pour la circulation du courant à mesurer, qui est disposée au voisinage des capteurs magnétorésistifs 90.

Dans le cas de mesure de courant, comme cela a été indiqué plus haut, la prévision de la distance entre la ligne conductrice et les capteurs magnétorésistifs est importante. Selon un exemple avantageux de réalisation, qui correspond à l'illustration de la Figure 5, la ligne conductrice 130 est intégrée au voisinage des capteurs 90 au cours même de la microfabrication de ceux-ci.

La ligne conductrice 130 présente avantageusement la même largeur que les capteurs 90 mais peut être un peu plus large que ceux-ci si nécessaire.

A titre d'exemple, avec une largeur de capteur 90 de 5 μm de largeur et une ligne conductrice intégrée 130, on peut mesurer des intensités de courant allant jusqu'à 100 mA avec une précision meilleure que 0.1%. Dans ce cas, la valeur du champ magnétique détectée par les capteurs 90 est d'environ 50 Oe.

Selon une variante de réalisation, adaptée à des intensités de courant plus élevées, un fil conducteur est placé sur la plaquette portant les capteurs 90 sur la face de la plaquette qui est opposée à celle portant les capteurs 90 et leurs connexions. La distance entre un capteur et le fil conducteur est alors donnée par l'épaisseur de la plaquette.

Selon encore un autre mode de réalisation, on peut utiliser un concentrateur de champ si l'on veut disposer de plus de liberté sur la position du fil conducteur par rapport aux capteurs.

Si l'on considère à nouveau les équations (1) et (2), on peut noter que les performances d'un capteur magnétorésistif dépendent des variations en fonction de la température.

Habituellement, la valeur $R_1$ décroît en fonction de la température tandis que la valeur $R_0$ augmente en fonction de la température.

La variation de la valeur $R_0$ en fonction de la température peut être supprimée à l'aide d'une configuration en demi-pont ou en pont de Wheatstone comportant plusieurs capteurs permettant une mesure différentielle.

La variation de la valeur $R_1$ en fonction de la température est plus difficile à compenser.

Toutefois, si le champ magnétique de polarisation $H_{bias}$ décroît lui-même selon la même loi que la valeur de $R_1$, l'équation (2) montre qu'au premier ordre, il s'opère une compensation de la décroissance de $R_1$.

Pour cela, on peut utiliser un aimant permanent avec une température critique suffisamment basse ou en appliquant un champ magnétique de polarisation $H_{bias}$ à l'aide d'une bobine comportant des moyens d'ajustement en fonction de la variation de température.

Dans ce cas, on peut appliquer un faible champ alternatif pour détecter la sensibilité du capteur et à l'aide d'une boucle de contre-réaction, on peut ajuster le courant dans la bobine afin de maintenir la sensibilité à la même valeur. Cette option permet de corriger correctement les variations de la valeur $R_1$ en fonction de la température.

Lorsque le champ magnétique de polarisation est engendré par un courant circulant dans une boucle, l'excitation peut être effectuée pendant la mesure du champ externe H soit par un courant constant, soit par des impulsions stabilisées à une valeur constante.

Selon une variante de réalisation, le champ magnétique de polarisation $H_{bias}$ est appliqué avec un angle α par rapport à la direction d'aimantation de la couche libre du capteur. La composante du champ de polarisation selon l'axe de la couche dure permet de centrer la réponse du capteur magnétorésistif et donc d'obtenir une réponse de capteur parfaitement symétrique.

On peut également appliquer sans contact le champ magnétique de polarisation $H_{bias}$. Du fait que la linéarité du capteur et sa plage de fonctionnement dépendent de l'intensité du champ magnétique de polarisation, le fait de changer la distance entre le champ de polarisation $H_{bias}$ et le capteur a pour résultat de changer la plage de fonctionnement.

Cette plage peut aussi être modifiée sans contact par modification de la distance entre les moyens d'application du champ magnétique de polarisation $H_{bias}$ et le capteur, pour ajuster la plage de fonctionnement à des valeurs requises. Ceci est avantageux en particulier lorsque le capteur est dans un environnement encapsulé et quand la grandeur à mesurer (champ magnétique H ou courant) change.

Pour effectuer ces ajustements, on peut soit changer la distance entre un aimant permanent et un capteur, soit ajuster la valeur du courant dans une bobine si le champ magnétique de polarisation $H_{bias}$ est appliqué à l'aide d'une bobine d'électro-aimant.

Si le champ magnétique de polarisation $H_{bias}$ appliqué est homogène, on voit d'après l'équation (2) que la sensibilité décroît en fonction du champ, conformément à l'équation (3), la décroissance s'effectuant selon le cube de la valeur du champ magnétique pour les champs élevés.

Lorsque l'on désire avoir une plus faible décroissance de la sensibilité, il est possible d'appliquer un champ de polarisation $H_{bias}$ inhomogène. Ceci peut être réalisé à l'aide d'aimants permanents ou de bobines.

On peut ainsi avoir différentes parties du système de mesure qui présentent des sensibilités différentes.

Lorsque l'on a un champ magnétique de polarisation $H_{bias}$ qui évolue linéairement entre une valeur nominale $H_{biasmin}$ et une valeur maximale $H_{biasmax}$, la réponse donnée par l'équation (2) est modifiée pour devenir la réponse donnée par l'équation (4) suivante :

$$R = R_0 + R_1 \cos\theta = R_0 + \frac{R_1}{(H_{bias\,max} - H_{bias\,min})} \int_{H_{bias\,min}}^{H_{bias\,max}} \frac{H}{\sqrt{H^2 + u^2}} du \qquad (4)$$

La sensibilité est alors donnée par l'équation suivante :

$$\frac{R_1}{(H_{bias\,max} - H_{bias\,min})} \int_{H_{bias\,min}}^{H_{bias\,max}} \frac{u^2}{\left(H^2 + u^2\right)^{3/2}} du \qquad (5).$$

## Revendications

1.  Procédé pour ajuster la sensibilité d'un dispositif comprenant au moins un capteur magnétorésistif (60 ; 70 ; 80 ; 90) et augmenter la plage de réponse de ce dispositif par rapport à un champ magnétique extérieur, consistant à appliquer un champ magnétique de polarisation prédéterminé connu $H_{bias}$ selon une direction telle qu'il présente une composante de champ non nulle perpendiculaire à une direction de détection dudit capteur magnétorésistif (60 ; 70 ; 80 ; 90) qui correspond également à une direction d'anisotropie d'une couche dudit capteur magnétorésistif, de telle sorte que le champ magnétique à mesurer puisse être déterminé par une fonction monotone à partir de la variation de résistance dudit capteur magnétorésistif (60; 70; 80; 90), **caractérisé en ce que** le champ magnétique de polarisation prédéterminé connu $H_{bias}$ n'est pas homogène et présente des variations connues entre une valeur minimale $H_{biasmin}$ et une valeur maximale $H_{biasmax}$.

2.  Procédé selon la revendication 1, **caractérisé en ce que** l'on fait évoluer linéairement le champ magnétique de polarisation entre la valeur minimale $H_{biasmin}$ et la valeur maximale $H_{biasmax}$ et **en ce que** la valeur R de la résistance dudit capteur magnétorésistif (60 ; 70 ; 80 ; 90) est donnée par l'équation suivante :

$$R = R_0 + \frac{R_1}{(H_{bias\,max} - H_{bias\,min})} \int_{H_{bias\,min}}^{H_{bias\,max}} \frac{H}{\sqrt{H^2 + u^2}} du$$

    où $R_0$ est la valeur de la résistance du capteur magnétorésistif en l'absence de champ extérieur,
    $R_1$ est la composante de la valeur de la résistance du capteur magnétorésistif qui est affectée par la présence d'un champ magnétique externe,
    H est le champ magnétique extérieur à mesurer, et
    u est la variable variant de la valeur minimale $H_{biasmin}$ à la valeur maximale $H_{biasmax}$ du champ magnétique de polarisation $H_{bias}$.

3.  Procédé selon la revendication 1 ou la revendication 2, pour ajuster la sensibilité d'un dispositif comprenant au moins un capteur à magnétorésistance anisotrope, **caractérisé en ce que** l'on applique le champ magnétique de polarisation prédéterminé connu $H_{bias}$ selon une direction telle qu'il présente une composante de champ non nulle selon une direction perpendiculaire à la direction de circulation du courant dans ledit capteur.

4.  Procédé selon la revendication 1 ou la revendication 2, pour ajuster la sensibilité d'un dispositif comprenant au moins un capteur (60) à magnétorésistance géante ou à magnétorésistance tunnel comportant une couche ferromagnétique dure (64) piégée dans une direction de référence, **caractérisé en ce que** l'on applique le champ magnétique de polarisation prédéterminé connu $H_{bias}$ selon une direction telle qu'il présente une composante de champ non nulle selon une direction perpendiculaire à ladite direction de référence de la couche ferromagnétique dure (64).

5.  Système pour mesurer des champs magnétiques ou des courants élevés à l'aide d'au moins un capteur magnétorésistif (60 ; 70 ; 80 ; 90), comprenant des moyens d'application d'un champ magnétique de polarisation prédéterminé connu $H_{bias}$ selon une direction telle qu'il présente une composante du champ non nulle perpendiculaire à une direction de détection dudit capteur magnétorésistif (60 ; 70 ; 80 ; 90) qui correspond également à une direction d'anisotropie d'une couche dudit capteur magnétorésistif, des moyens de mesure de la variation de résistance dudit capteur magnétorésistif (60 ; 70 ; 80 ; 90) et des moyens de détermination du champ magnétique extérieur à mesurer H à partir de ladite variation de résistance mesurée, la résistance du capteur étant soumise à une fonction monotone de variation, **caractérisé en ce qu'**il comprend des moyens pour faire varier de façon connue le champ magnétique de polarisation prédéterminé $H_{bias}$ entre une valeur minimale $H_{biasmin}$ et une valeur maximale $H_{biasmax}$.

**6.** Système selon la revendication 5, **caractérisé en ce que** ledit capteur magnétorésistif est une magnétorésistance anisotrope et **en ce que** les moyens d'application d'un champ magnétique de polarisation prédéterminé connu $H_{bias}$ sont adaptés pour que ledit champ présente une composante de champ non nulle perpendiculaire à la circulation de courant dans ledit capteur.

**7.** Système selon la revendication 5, **caractérisé en ce que** ledit capteur magnétorésistif (60) est un capteur à magnétorésistance géante ou un capteur à magnétorésistance tunnel comportant une couche ferromagnétique dure (64) piégée dans une direction de référence et **en ce que** les moyens d'application d'un champ magnétique de polarisation prédéterminé connu $H_{bias}$ sont adaptés pour que ledit champ présente une composante de champ non nulle selon une direction perpendiculaire à ladite direction de référence de la couche ferromagnétique dure (64).

**8.** Système selon la revendication 6 ou la revendication 7, **caractérisé en ce que** le capteur magnétorésistif (70 ; 80 ; 90) présente une forme de C à coins carrés ou une forme de serpentin avec des bras transversaux (72 ; 82) de faible longueur et des bras longitudinaux (71 ; 81) de plus grande longueur, ces derniers étant alignés selon la direction de l'axe de facile aimantation de couches ferromagnétiques douces contenues dans ledit capteur et selon la direction dudit champ magnétique de polarisation prédéterminé connu $H_{bias}$.

**9.** Système selon l'une quelconque des revendications 5 à 8, **caractérisé en ce que** les moyens d'application d'un champ magnétique de polarisation prédéterminé connu $H_{bias}$ comprennent au moins un aimant permanent (110 ; 121, 122).

**10.** Système selon la revendication 9, **caractérisé en ce que** ledit aimant permanent est placé au-dessus ou au-dessous dudit capteur magnétorésistif et possède une aimantation planaire.

**11.** Système selon la revendication 9, **caractérisé en ce qu'**il comprend au moins un aimant permanent (121, 122) placé à côté dudit capteur magnétorésistif avec une aimantation dirigée de manière à créer dans ledit capteur un champ planaire.

**12.** Système selon l'une quelconque des revendications 9 à 11, **caractérisé en ce que** l'aimant permanent (110 ; 121, 122) est adapté pour que les variations thermiques du champ magnétique rémanent créé par l'aimant permanent (110 ; 121, 122) compensent la variation de sensibilité des capteurs magnétorésistifs.

**13.** Système selon l'une quelconque des revendications 9 à 12, **caractérisé en ce que** l'aimant permanent est formé par électrodéposition.

**14.** Système selon l'une quelconque des revendications 9 à 12, **caractérisé en ce que** l'aimant permanent est formé par sérigraphie ou lithographie de couches magnétiques déposées.

**15.** Système selon l'une quelconque des revendications 5 à 8, **caractérisé en ce que** les moyens d'application d'un champ magnétique de polarisation prédéterminé connu $H_{bias}$ comprennent au moins une bobine d'électroaimant.

**16.** Système selon la revendication 5, **caractérisé en ce qu'**il comprend des moyens d'ajustement du courant circulant dans ladite bobine d'électroaimant pour compenser les variations thermiques de sensibilité du capteur magnétorésistif.

**17.** Système selon l'une quelconque des revendications 5 à 16, **caractérisé en ce que** ledit capteur magnétorésistif (90) est placé à proximité d'un fil conducteur (130) traversé par un courant dont l'intensité est à déterminer, **en ce qu'**il comprend des moyens de détermination de ladite intensité dudit courant à partir de la valeur du champ magnétique produit par ledit courant et détecté par ledit capteur magnétorésistif (90), et **en ce que** ledit capteur magnétorésistif (90) et ledit fil conducteur (130) sont disposés de telle manière que ledit champ magnétique détecté soit perpendiculaire audit champ magnétique de polarisation prédéterminé connu $H_{bias}$.

**Patentansprüche**

**1.** Verfahren, um die Sensibilität einer Vorrichtung, die mindestens einen magnetoresistiven Sensor (60; 70; 80; 90) umfasst, zu justieren und den Reaktionsbereich dieser Vorrichtung in Bezug auf ein externes Magnetfeld zu vergrößern, darin bestehend, ein bekanntes vorbestimmtes Polarisationsmagnetfeld $H_{bias}$ in eine Richtung anzulegen, so dass es eine Feldkomponente ungleich Null senkrecht auf eine Erfassungsrichtung des magnetoresistiven Sensors (60; 70; 80; 90), die auch einer Anisotropie-Richtung einer Schicht des magnetoresistiven Sensors entspricht, aufweist, so dass das zu messende Magnetfeld durch eine monotone Funktion auf Basis der Variation des Widerstands des magnetoresistiven Sensors (60; 70; 80; 90) bestimmt werden kann, **dadurch gekennzeichnet, dass** das bekannte vorbestimmte Polarisationsmagnetfeld $H_{bias}$ nicht homogen ist und bekannte Variationen zwischen einem Mindestwert $H_{biasmin}$ und einem Höchstwert $H_{biasmax}$ aufweist.

2. Verfahren gemäß Anspruch 1, **dadurch gekennzeichnet, dass** das Polarisationsmagnetfeld linear zwischen dem Mindestwert $H_{biasmin}$ und dem Höchstwert $H_{biasmax}$ weiterentwickelt wird, und dass der Wert R des Widerstands des magnetoresistiven Sensors (60; 70; 80; 90) durch folgende Gleichung gegeben ist:

$$R = R_0 + \frac{R_1}{(H_{bias\,max} - H_{bias\,min})} \int_{H_{bias\,min}}^{H_{bias\,max}} \frac{H}{\sqrt{H^2 + u^2}} du$$

wobei $R_0$ der Wert des Widerstands des magnetoresistiven Sensors bei Nichtvorhandensein eines externen Feldes ist,

$R_1$ die Komponente des Werts des Widerstands des magnetoresistiven Sensors ist, die durch das Vorhandensein eines externen Magnetfeldes zugeordnet wird,

H das zu messende externe Magnetfeld ist, und

u die Variable ist, die den Mindestwert $H_{biasmin}$ auf den Höchstwert $H_{biasmax}$ des Polarisationsfeldes $H_{bias}$ variiert.

3. Verfahren gemäß Anspruch 1 oder Anspruch 2, um die Sensibilität einer Vorrichtung, umfassend mindestens einen Sensor mit anisotropem Magnetowiderstand, zu justieren, **dadurch gekennzeichnet, dass** das bekannte vorbestimmte Polarisationsmagnetfeld $H_{bias}$ in eine derartige Richtung angelegt wird, dass es eine Feldkomponente ungleich Null in eine Richtung senkrecht auf die Zirkulationsrichtung des Stroms in dem Sensor aufweist.

4. Verfahren gemäß Anspruch 1 oder Anspruch 2, um die Sensibilität einer Vorrichtung, umfassend mindestens einen Sensor (60) mit Riesenmagnetowiderstand oder mit Tunneleffekt-Magnetowiderstand, umfassend eine harte ferromagnetische Schicht (64), die in eine Referenzrichtung eingeschlossen ist, zu justieren, **dadurch gekennzeichnet, dass** das bekannte vorbestimmte Polarisationsmagnetfeld $H_{bias}$ in eine derartige Richtung angelegt wird, dass es eine Feldkomponente ungleich Null in eine Richtung senkrecht auf die Referenzrichtung der harten ferromagnetischen Schicht (64) aufweist.

5. System zum Messen von Magnetfeldern oder hohen Strömen mit Hilfe mindestens eines magnetoresistiven Sensors (60; 70; 80; 90), umfassend Mittel zum Anlegen eines bekannten vorbestimmten Polarisationsmagnetfeldes $H_{bias}$ in eine derartige Richtung, dass es eine Feldkomponente ungleich Null senkrecht auf eine Erfassungsrichtung des magnetoresistiven Sensors (60; 70; 80; 90) aufweist, die auch einer Anisotropie-Richtung einer Schicht des magnetoresistiven Sensors entspricht, Mittel zum Messen der Variation des Widerstands des magnetoresistiven Sensors (60; 70; 80; 90) und Mittel zur Bestimmung des zu messenden externen Magnetfeldes H auf Basis der gemessenen Widerstandsvariation, wobei der Widerstand des Sensors einer monotonen Variationsfunktion unterliegt, **dadurch gekennzeichnet, dass** es Mittel umfasst, um auf bekannte Weise das vorbestimmte Polarisationsmagnetfeld $H_{bias}$ zwischen einem Mindestwert $H_{biasmin}$ und einem Höchstwert $H_{biasmax}$ zu variieren.

6. System gemäß Anspruch 5, **dadurch gekennzeichnet, dass** der magnetoresistive Sensor ein anisotroper Magnetowiderstand ist, und dass die Mittle zum Anlegen eines bekannten vorbestimmten Polarisationsmagnetfeldes $H_{bias}$ derart vorgesehen sind, dass das Feld eine Feldkomponente ungleich Null senkrecht auf die Stromzirkulation in dem Sensor aufweist.

7. System gemäß Anspruch 5, **dadurch gekennzeichnet, dass** der magnetoresistive Sensor (60) ein Sensor mit Riesenmagnetowiderstand oder ein Sensor mit Tunneleffekt-Magnetowiderstand ist, umfassend eine harte ferromagnetische Schicht (64), die in eine Referenzrichtung eingeschlossen ist, und dass die Mittel zum Anlegen eines bekannten vorbestimmten Polarisationsmagnetfeldes $H_{bias}$ derart vorgesehen sind, dass das Feld eine Feldkomponente ungleich Null in eine Richtung senkrecht auf die Referenzrichtung der harten ferromagnetischen Schicht (64) aufweist.

8. System gemäß Anspruch 6 oder Anspruch 7, **dadurch gekennzeichnet, dass** der magnetoresistive Sensor (70;

80; 90) eine Form eines C mit quadratischen Ecken oder eine Schlangenform mit Querarmen (72; 82) von geringer Länge und Längsarmen (71; 81) von größerer Länge aufweist, wobei diese letztgenannten in die Richtung der Achse mit leichter Magnetisierung von in dem Sensor enthaltenen sanft ferromagnetischen Schichten und in die Richtung des bekannten vorbestimmten Polarisationsmagnetfeldes $H_{bias}$ ausgerichtet sind.

9. System gemäß einem der Ansprüche 5 bis 8, **dadurch gekennzeichnet, dass** die Mittel zum Anlegen eines bekannten vorbestimmten Polarisationsmagnetfeldes $H_{bias}$ mindestens einen Dauermagneten (110; 121; 122) umfassen.

10. System gemäß Anspruch 9, **dadurch gekennzeichnet, dass** der Dauermagnet über oder unter dem magnetoresistiven Sensor angeordnet ist und eine planare Magnetisierung besitzt.

11. System gemäß Anspruch 9, **dadurch gekennzeichnet, dass** es mindestens einen Dauermagneten (121, 122) umfasst, der neben dem magnetoresistiven Sensor angeordnet ist, mit einer Magnetisierung, die derart ausgerichtet ist, dass in dem Sensor ein planares Feld erzeugt wird.

12. System gemäß einem der Ansprüche 9 bis 11, **dadurch gekennzeichnet, dass** der Dauermagnet (110; 121, 122) dazu vorgesehen ist, dass die thermischen Variationen des remanenten Magnetfeldes, das von dem Dauermagneten (110; 121, 122) erzeugt wird, die Sensibilitätsvariation der magnetoresistiven Sensoren ausgleichen.

13. System gemäß einem der Ansprüche 9 bis 12, **dadurch gekennzeichnet, dass** der Dauermagnet durch Elektrobeschichtung gebildet ist.

14. System gemäß einem der Ansprüche 9 bis 12, **dadurch gekennzeichnet, dass** der Dauermagnet durch Siebdruck oder Lithographie von aufgebrachten Magnetschichten gebildet ist.

15. System gemäß einem der Ansprüche 5 bis 8, **dadurch gekennzeichnet, dass** die Mittel zum Anlegen eines bekannten vorbestimmten Polarisationsmagnetfeldes $H_{bias}$ mindestens eine Elektromagnetspule umfassen.

16. System gemäß Anspruch 5, **dadurch gekennzeichnet, dass** es Mittel zum Justieren des in der Elektromagnetspule zirkulierenden Stroms umfasst, um die thermischen Sensibilitätsvariationen des magnetoresistiven Sensors auszugleichen.

17. System gemäß einem der Ansprüche 5 bis 16, **dadurch gekennzeichnet, dass** der magnetoresistive Sensor (90) in der Nähe eines leitenden Drahtes (130) angeordnet ist, durch den ein Strom fließt, dessen Stärke zu bestimmen ist, dass es Mittel zur Bestimmung der Stärke des Stroms auf Basis des Werts des von dem Strom erzeugten und von dem magnetoresistiven Sensor (90) erfassten Magnetfeldes umfasst, und dass der magnetoresistive Sensor (90) und der leitende Draht (130) derart angeordnet sind, dass das erfasst Magnetfeld senkrecht auf das bekannte vorbestimmte Polarisationsmagnetfeld $H_{bias}$ ist.

**Claims**

1. A method of adjusting the sensitivity of a device including a magnetoresistive sensor (60; 70; 80; 90) and increasing the range of response of that device to an external magnetic field, consisting in applying a known predetermined magnetic bias field $H_{bias}$ in a direction such that it has a non-zero component of the field perpendicular to a detection direction of said magnetoresistive sensor (60; 70; 80; 90) that also corresponds to a direction of anisotropy of a layer of the magnetoresistive sensor, so that the magnetic field to be measured can be determined by a monotonic function from the resistance variation of said magnetoresistive sensor (60; 70; 80; 90), **characterized in that** the predetermined magnetic bias field $H_{bias}$ is not homogeneous and is subject to known variations between a minimum value $H_{biasmin}$ and a maximum value $H_{biasmax}$.

2. A method according to claim 1
wherein the bias magnetic field is caused to vary linearly between the minimum value $H_{biasmin}$ and the maximum value $H_{biasmax}$, and
wherein the resistance R of said magnetoresistive sensor is given by the following equation :

$$R = R_0 + \frac{R_1}{(H_{bias\,max} - H_{bias\,min})} \int\limits_{H_{bias\,min}}^{H_{bias\,max}} \frac{H}{\sqrt{H^2 + u^2}} du$$

were :

$R_o$ is the resistance of the magnetoresistive sensor in the absence of an external field ;

$R_1$ is the component of the resistance of the magnetoresistive sensor that is affected by the presence of an external magnetic field ;

H is the external magnetic field to be measured ; and

u is the variable varying from the minimum value $H_{biasmin}$ to the maximum value $H_{biasmax}$ of the bias magnetic field $H_{bias}$.

3. A method according to claim 1 or claim 2, for adjusting the sensitivity of a device including an anisotropic magnetoresistance sensor, **characterized in that** the known predetermined bias magnetic field $H_{bias}$ is applied in a direction such that it has a non-zero field component in a direction perpendicular to the direction of flow of the current in said sensor.

4. A method according to claim 1 or claim 2, for adjusting the sensitivity of a device including a giant magnetoresistance sensor (60) or a tunnel magnetoresistance sensor (60) including a hard ferromagnetic layer (64) trapped in a reference direction, **characterized in that** the known predetermined bias magnetic field $H_{bias}$ is applied in a direction such that it has a non-zero field component in a direction perpendicular to said reference direction of the hard ferromagnetic layer (64).

5. A system for measuring high currents or magnetic fields using a magnetoresistive sensor (60; 70; 80; 90), including means for applying a known predetermined magnetic bias field $H_{bias}$ in a direction such that it has a non-zero component of the field perpendicular to a detection direction of the magnetoresistive sensor (60; 70; 80; 90) that also corresponds to a direction of anisotropy of a layer of said magnetoresistive sensor, means for measuring the variation in resistance of said magnetoresistive sensor (60; 70; 80; 90), and means for determining the external magnetic field H to be measured from the measured resistance variation, the resistance of the sensor being subjected to a monotonic variation function, **characterized in that** it comprises means for causing the predetermined bias magnetic field $H_{bias}$ to vary in known manner between a minimum value $H_{biasmin}$ and a maximum value $H_{biasmax}$.

6. A system according to claim 5, **characterized in that** said magnetoresistive sensor is an anisotropic magnetoresistance and the means for applying a known predetermined bias magnetic field $H_{bias}$ are such that said field has a non-zero field component perpendicular to the flow of current in said sensor.

7. A system according to claim 5, **characterized in that** said magnetoresistive sensor (60) is a giant magnetoresistance sensor or a tunnel magnetoresistance sensor including a hard ferromagnetic layer (64) trapped in a reference direction and the means for applying a known predetermined bias magnetic field $H_{bias}$ are such that said field has a non-zero field component in a direction perpendicular to said reference direction of the hard ferromagnetic layer (64).

8. A system according to claim 6 or claim 7, **characterized in that** the magnetoresistive sensor (70; 80; 90) is C-shaped with square corners or of serpentine shape with short transverse arms (72; 82) and longer longitudinal arms (71; 81), the longer arms being aligned in the direction of the axis of easy magnetization of soft ferromagnetic layers in said sensor and in the direction of said known predetermined bias magnetic field $H_{bias}$.

9. A system according to any one of claims 5 to 8, **characterized in that** the means for applying a known predetermined bias magnetic field $H_{bias}$ include a permanent magnet (110; 121; 122).

10. A system according to claim 9, **characterized in that** said permanent magnet is above or below said magnetoresistive sensor and has planar magnetization.

11. A system according to claim 10, **characterized in that** it includes at least a permanent magnet (121, 122) alongside said magnetoresistive sensor with its magnetization directed to create a planar field in said sensor.

12. A system according to any one of claims 9 to 11, **characterized in that** the permanent magnet (110; 121, 122) is such that the thermal variations of the remanent magnetic field created by the permanent magnet (110; 121, 122) compensate the variation in the sensitivity of the magnetoresistive sensors.

**13.** A system according to any one of claims 9 to 12, **characterized in that** the permanent magnet is formed by electrodeposition.

**14.** A system according to any one of claims 9 to 12, **characterized in that** the permanent magnet is formed by screenprinting or lithographically printing deposited magnetic layers.

**15.** A system according to any one of claims 5 to 8, **characterized in that** the means for applying a known predetermined bias magnetic field $H_{bias}$ include an electromagnet.

**16.** A system according to claim 5, **characterized in that** it includes means for adjusting the current flowing in said electromagnet to compensate the thermal variations in the sensitivity of the magnetoresistive sensor.

**17.** A system according to any one of claims 5 to 16, **characterized in that** said magnetoresistive sensor (90) is placed near a conductive wire (130) carrying a current to be measured, it includes means for determining said current from the value of the magnetic field produced by said current and detected by said magnetoresistive sensor (90), and said magnetoresistive sensor (9) and said conductive wire (130) are disposed so that said detected magnetic field is perpendicular to said known predetermined bias magnetic field $H_{bias}$.

FIG.1

$H_{bias}$

FIG.2A

$H_{bias}$

FIG.2B

FIG.2C

H<sub>bias</sub>

FIG.3

FIG.4

FIG.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- GB 2272561 A
- WO 9535508 A
- US 7054118 B2
- WO 9628812 A
- DE 1011313 A